(19) Europäisches Patentamt / European Patent Office / Office européen des brevets

(11) **EP 4 078 816 B1**

(12) **FASCICULE DE BREVET EUROPEEN**

(45) Date de publication et mention de la délivrance du brevet:
**21.08.2024 Bulletin 2024/34**

(21) Numéro de dépôt: **20819792.1**

(22) Date de dépôt: **10.12.2020**

(51) Classification Internationale des Brevets (IPC):
**H03M 7/04** *(2006.01)* **H03M 7/28** *(2006.01)*
**G06F 17/16** *(2006.01)*

(52) Classification Coopérative des Brevets (CPC):
**H03M 7/04; G06F 7/5443; G06N 3/048;**
**G06N 3/063; H03M 7/28;** G06F 2207/4824

(86) Numéro de dépôt international:
**PCT/EP2020/085416**

(87) Numéro de publication internationale:
**WO 2021/122260 (24.06.2021 Gazette 2021/25)**

(54) **PROCEDE ET DISPOSITIF DE CODAGE BINAIRE DE SIGNAUX POUR IMPLEMENTER DES OPERATIONS MAC NUMERIQUES A PRECISION DYNAMIQUE**

VERFAHREN UND VORRICHTUNG ZUR BINÄREN CODIERUNG VON SIGNALEN ZUR IMPLEMENTIERUNG DIGITALER MAC OPERATIONEN MIT DYNAMISCHER GENAUIGKEIT

METHOD AND DEVICE FOR BINARY CODING OF SIGNALS IN ORDER TO IMPLEMENT DIGITAL MAC OPERATIONS WITH DYNAMIC PRECISION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2019 FR 1914704**

(43) Date de publication de la demande:
**26.10.2022 Bulletin 2022/43**

(73) Titulaire: **Commissariat à l'Energie Atomique et aux Energies Alternatives**
**75015 Paris (FR)**

(72) Inventeurs:
• **THIELE, Johannes Christian**
**91191 Gif sur Yvette Cedex (FR)**
• **BICHLER, Olivier**
**78125 Vieille Eglise en Yvelines (FR)**
• **DURANTON, Marc**
**91190 Orsay (FR)**
• **LORRAIN, Vincent**
**91160 Saulx-les-Chartreux (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
EP-A1- 3 343 392       EP-A1- 3 343 392
US-A1- 2016 358 069    US-A1- 2016 358 069
US-A1- 2019 065 150    US-A1- 2019 065 150
US-B1- 9 818 059       US-B1- 9 818 059

Processed by Luminess, 75001 PARIS (FR)

**Description**

L'invention concerne le domaine des architectures de calcul pour les modèles d'apprentissage automatique ou « machine learning », en particulier les réseaux de neurones artificiels et porte sur un procédé et un dispositif de codage et intégration de signaux numériques à précision dynamique adapté aux signaux propagés dans un réseau de neurones artificiels.

Plus généralement, l'invention est applicable à toute architecture de calcul implémentant des opérations de type multiplication puis accumulation (MAC).

Les réseaux de neurones artificiels constituent des modèles de calculs imitant le fonctionnement des réseaux de neurones biologiques. Les réseaux de neurones artificiels comprennent des neurones interconnectés entre eux par des synapses, qui sont classiquement implémentées par des mémoires numériques. Les synapses peuvent être également implémentées par des composants résistifs dont la conductance varie en fonction de la tension appliquée à leurs bornes. Les réseaux de neurones artificiels sont utilisés dans différents domaines de traitement du signal (visuel, sonore, ou autre) comme par exemple dans le domaine de la classification d'image ou de la reconnaissance d'image.

Un problème général pour les architectures de calculateurs implémentant un réseau de neurones artificiels concerne la consommation globale d'énergie du circuit réalisant le réseau.

L'opération de base mise en oeuvre par un neurone artificiel est une opération de multiplication puis accumulation MAC. Selon le nombre de neurones par couche et de couches de neurones que comporte le réseau, le nombre d'opérations MAC par unité de temps nécessaire pour un fonctionnement temps réel devient contraignant.

Il existe donc un besoin pour développer des architectures de calcul optimisées pour les réseaux de neurones qui permettent de limiter le nombre d'opérations MAC sans dégrader ni les performances des algorithmes mis en oeuvre par le réseau ni la précision des calculs.

La demande internationale WO 2016/050595 du Demandeur décrit une méthode de codage de signaux permettant de simplifier l'implémentation de l'opérateur MAC.

Un inconvénient de cette méthode est qu'elle ne permet pas de prendre en compte la nature des signaux propagés dans le réseau de neurones. En particulier, lorsque la densité de valeurs à 0 dans les signaux numériques propagés dans le réseau est importante, des opérations inutiles sont effectuées si le codage des signaux ne prend pas en compte cette particularité. US2019/065150 A1 (HEDDES MATTHEUS CORNELIS ANTONIUS ADRIANUS [US] ET AL, 2019-02-28), US9818059 B1 (WOO DONG HYUK [US] ET AL, 2017-11-14), US2016/358069 A1 (BROTHERS JOHN W [US] ET AL, 2016-12-08) et EP3343392 A1 (INTEL CORP [US], 2018-07-04) décrivent des autres méthodes de codage de signaux permettant de simplifier l'implémentation de l'opérateur mac.

L'invention propose une méthode de codage à précision dynamique qui permet de prendre en compte la nature des signaux à coder, en particulier la densité de valeurs à 0.

De par son aspect dynamique, l'invention permet d'optimiser le codage des signaux propagés dans un réseau de neurones de manière à limiter le nombre d'opérations MAC réalisées et ainsi limiter la consommation d'énergie du circuit réalisant le réseau.

L'invention a pour objet un procédé, mis en oeuvre par ordinateur, tel que défini par la revendication 1. Des aspects particuliers du procédé de l'invention sont définis par les revendications 2-5.

L'invention a aussi pour objet un dispositif de codage comprenant un codeur configuré pour exécuter le procédé de codage selon l'invention, tel que défini par la revendication 6.

L'invention a aussi pour objet un dispositif d'intégration configuré pour réaliser une opération de multiplication puis accumulation MAC entre un premier nombre codé au moyen du procédé de codage selon l'invention et un coefficient de pondération, tel que défini par la revendication 7.

L'invention a aussi pour objet un neurone artificiel, tel que défini par la revendication 8.

L'invention a aussi pour objet un neurone artificiel, tel que défini par la revendication 9.

L'invention a aussi pour objet un réseau de neurones artificiels tel que défini par la revendication 10.

D'autres caractéristiques et avantages de la présente invention apparaîtront mieux à la lecture de la description qui suit en relation aux dessins annexés suivants.

[Fig. 1] la figure 1 représente un organigramme illustrant les étapes de mise en oeuvre du procédé de codage selon l'invention,

[Fig. 2] la figure 2 représente un schéma d'un codeur selon un mode de réalisation de l'invention,

[Fig. 3] la figure 3 représente un schéma d'un module d'intégration pour réaliser une opération de type MAC pour des nombres quantifiés via la méthode de codage de la figure 1,

[Fig. 4] la figure 4 représente un schéma fonctionnel d'un exemple de neurone artificiel comprenant un module d'intégration du type de la figure 3 pour un fonctionnement lors d'une phase de propagation de données,

[Fig. 5] la figure 5 représente un schéma fonctionnel d'un exemple de neurone artificiel comprenant un module d'intégration du type de la figure 3 pour un fonctionnement lors d'une phase de rétro-propagation de données.

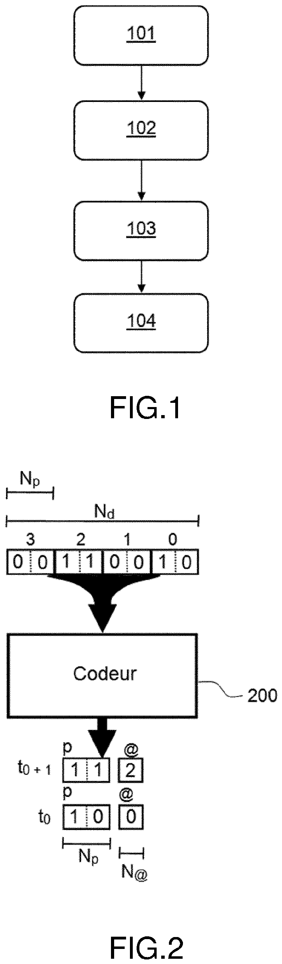

La figure 1 représente, sur un organigramme, les étapes de mise en oeuvre d'un procédé de codage selon un mode de réalisation de l'invention.

Un objectif du procédé est de coder un nombre quantifié sur $N_d$ bits en un groupe de valeurs codées qui peuvent être transmises (ou propagées) indépendamment sous forme d'évènements.

A cet effet, la première étape 101 du procédé consiste à recevoir un nombre y quantifié sur $N_d$ bits, $N_d$ étant un nombre entier. Le nombre y est, typiquement, un échantillon quantifié d'un signal, par exemple un signal d'image, un signal audio ou un signal de données comprenant intrinsèquement une information.

Dans une deuxième étape 102, le nombre y est décomposé en plusieurs mots binaires de tailles respectives égales à $N_p$. Le nombre de mots binaires est égal à $N_d/N_p$ avec la contrainte que $N_d \bmod N_p = 0$, mod désignant la fonction modulo. La taille Np d'un mot binaire est déterminée en fonction de la distribution statistique des valeurs à 0 des bits du signal numérique, de manière à minimiser la consommation d'énergie dudit système de calcul numérique.

Par exemple, si y=50={00110010}, ce nombre de $N_d$=8 bits peut être décomposé en quatre mots de 2 bits {00},{11},{00},{10}.

Dans une troisième étape 103, le nombre y est codé par un ensemble de couples de valeurs, chaque couple comprenant l'un des mots binaires non nul et une adresse correspondant à la position du mot binaire dans le nombre y.

En reprenant l'exemple précédent, le nombre y=50 est codé par les couples (2,{11}) et (0,{10}). Les mots binaires nuls {00} sont supprimés car ils n'apportent pas d'information et peuvent être omis dans le cas où les valeurs codées sont des signaux propagés dans un réseau de neurones comme cela sera détaillé par la suite.

Le nombre de bits utilisé pour coder les adresses (ou positions) de chaque mot binaire est égal à $N_@$=ceil($\log_2(N_d/N_p)$), où ceil() désigne la fonction partie entière supérieure.

Dans une dernière étape 104, les signaux codés sont transmis, par exemple via un bus de données de taille appropriée vers un opérateur MAC en vue de réaliser une opération de multiplication puis accumulation.

Dans une variante de réalisation, les couples de valeurs associées aux mots binaires nuls sont transmis mais ne sont pas exploités lorsqu'ils sont reçus.

Dans une autre variante de réalisation, lorsque la même adresse est utilisée pour des valeurs codées appartenant à des échantillons différents, cette adresse est transmise une seule fois. Dans ce cas, tous les mots binaires ayant la même adresse et appartenant à différents échantillons sont transmis de façon groupée (soit simultanément soit successivement) en ne transmettant l'adresse qu'une seule fois.

La figure 2 représente, sous forme schématique, un exemple de codeur 200 configuré pour coder une valeur y d'entrée en appliquant le procédé décrit à la figure 1. Sur la figure 2, on a repris l'exemple numérique non limitatif pour y=50.

Le couple de valeurs ({10},0) est transmis à un instant $t_0$. Le couple de valeurs ({11},2) est transmis à un instant suivant $t_0$+1. L'ordre de transmission des valeurs est un paramètre de l'invention.

Un avantage de la méthode de codage proposée est qu'elle permet de limiter la taille des données codées transmises en supprimant les valeurs à 0. Un autre avantage réside dans son aspect dynamique car le paramètre $N_p$ peut être aussi adapté selon la nature des données à coder ou en fonction des contraintes de dimensionnement des opérateurs utilisés pour réaliser des calculs sur les données codées.

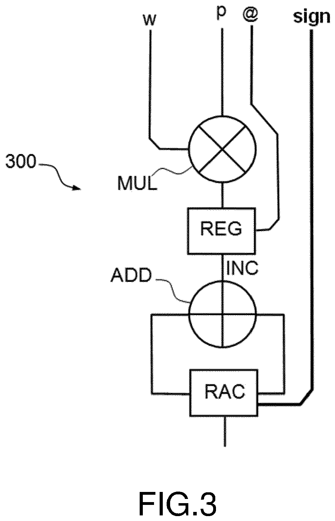

La figure 3 représente schématiquement un module d'intégration 300 configuré pour réaliser une opération de type multiplication puis addition ou opération MAC. Le module d'intégration 300 décrit à la figure 3 est optimisé pour traiter des données codées via la méthode selon l'invention. Typiquement, le module d'intégration 300 implémente une opération MAC entre une donnée d'entrée p codée via la méthode de codage selon l'invention et un coefficient de pondération w qui correspond à un paramètre appris par un modèle d'apprentissage automatique. Le coefficient w correspond par exemple à un poids synaptique dans un réseau de neurones artificiels.

Un module d'intégration 300 du type décrit à la figure 3 peut être dupliqué pour réaliser en parallèle des opérations MAC entre plusieurs valeurs d'entrée p et plusieurs coefficients w.

Alternativement, un seul et même module d'intégration peut être activé séquentiellement pour réaliser plusieurs opérations MAC successives.

Le module d'intégration 300 comprend un multiplieur MUL, un registre à décalage REG, un additionneur ADD et un registre d'accumulation RAC. Lorsque le module d'intégration 300 reçoit une donnée codée sous la forme (@,p), il effectue le produit de p avec un coefficient de pondération w, puis le résultat en sortie du multiplieur MUL est décalé vers la gauche de la valeur de l'adresse @ multiplié par $N_p$. L'opération de décalage binaire correspond à une multiplication du résultat par la valeur $2^{(@ \cdot N_p)}$.

Le résultat INC en sortie du registre à décalage REG est ensuite additionné au résultat en mémoire dans le registre d'accumulation RAC.

La valeur en mémoire dans le registre RAC est transmise et le registre RAC est remis à zéro lorsque le module d'intégration 300 reçoit une nouvelle donnée avec une adresse @ à 0.

Ainsi, le module d'intégration 300 est configuré pour réaliser l'opération :

$$ACC < -ACC + w \cdot p \cdot 2^{(@ \cdot N_p)}$$

La taille du registre RAC doit être supérieure à la somme des tailles maximales des valeurs w et p. Typiquement, il sera de la taille $N_d + N_w$, qui est la taille maximale d'une opération MAC entre des mots de tailles $N_d$ et $N_w$.

Dans le cas particulier où $N_p=1$, p prend toujours la valeur 1 ou 0. Dans ce cas, il suffit de propager uniquement l'adresse @, la valeur de p associée étant forcément égale à 1 (puisque les valeurs 0 ne sont pas propagées).

Ainsi, le module d'intégration 300 réalise une opération MAC avec une complexité réduite puisque l'opération de multiplication est réalisée pour des nombres de taille plus réduite, par rapport à une implémentation classique.

Dans la variante de réalisation où tous les mots binaires appartenant à différents échantillons et ayant la même adresse sont transmis ensemble, l'intégration de chaque échantillon peut être réalisée en parallèle via plusieurs modules d'intégration du type décrit à la figure 3.

Dans une variante de réalisation, lorsque les nombres sont représentés en notation signée, un module de gestion du signe (non représenté en détail sur la figure 3) est aussi nécessaire.

Dans une autre variante de réalisation, afin de limiter encore le nombre d'opérations, seuls une partie des bits les plus significatifs peuvent être transmis une fois le nombre codé.

En reprenant l'exemple précédent pour y= 50={00110010}, ce nombre peut être codé par les évènements {2,11} puis {0,10}. Pour alléger encore le nombre d'opérations, on peut décider de ne propager que le premier évènement correspondant aux bits les plus significatifs, à savoir {2,11} dans cet exemple. Cette variante est adaptée aux applications qui sont moins contraintes en termes de précision car elle induit un bruit de quantification plus important.

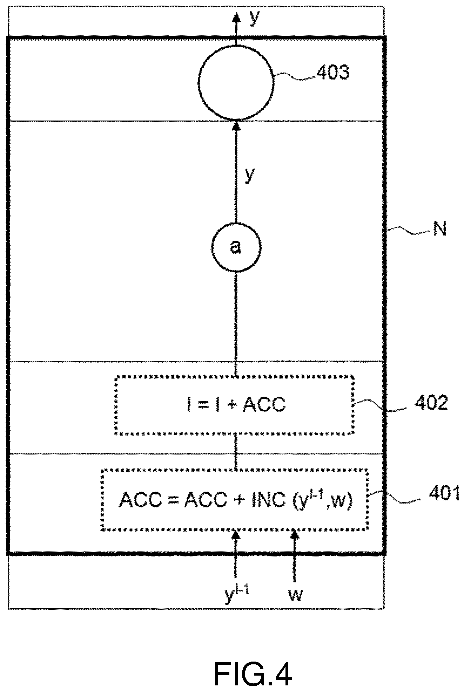

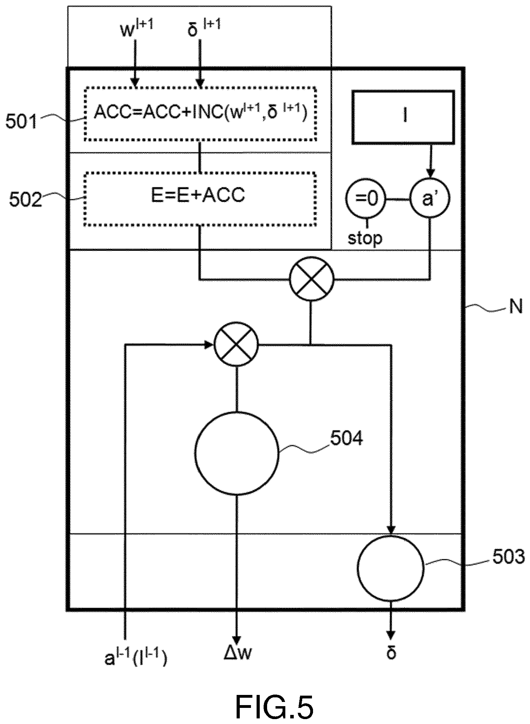

Le module d'intégration 300 selon l'invention peut être avantageusement utilisé pour implémenter un réseau de neurones artificiels comme illustré aux figures 4 et 5.

La figure 4 représente schématiquement un circuit ou processeur ou plus généralement un calculateur configuré pour réaliser une fonction d'apprentissage automatique, par exemple sous la forme d'un neurone artificiel.

Typiquement, la fonction implémentée par un modèle d'apprentissage automatique consiste en une intégration des signaux reçus en entrée et pondérés par des coefficients.

Dans le cas particulier d'un réseau de neurones artificiels, les coefficients sont appelés poids synaptiques et la somme pondérée est suivi par l'application d'une fonction d'activation a qui, en fonction du résultat de l'intégration, génère un signal à propager en sortie du neurone.

Ainsi, le neurone artificiel N comprend un premier module d'intégration 401 du type de la figure 3 pour réaliser le produit $y^{l-1}.w$, avec $y^{l-1}$ une valeur codée via la méthode selon l'invention sous forme de plusieurs évènements successivement propagés entre deux neurones et w la valeur d'un poids synaptique. Un second module d'intégration 402 classique est ensuite utilisé pour intégrer les produits $y^{l-1}.w$ dans le temps.

Sans sortir du cadre de l'invention, un neurone artificiel N peut comprendre plusieurs modules d'intégration pour réaliser des opérations MAC en parallèle pour plusieurs données d'entrée et coefficients de pondération.

La fonction d'activation a est, par exemple, définie par la génération d'un signal lorsque l'intégration des signaux reçus est terminée. Le signal d'activation est ensuite codé via un codeur 403 selon l'invention (tel que décrit à la figure 2) qui code la valeur en plusieurs évènements qui sont propagés successivement vers un ou plusieurs autre(s) neurone(s).

Plus généralement la valeur de sortie de la fonction d'activation $a^l$ d'un neurone d'une couche d'indice I est donnée par la relation suivante :

[Math. 1]

$$y_i^l = a^l\left(\sum_j y_j^{l-1} w_{ij}^l + b_i^l\right) = a^l\left(I_i^l\right) \quad (1)$$

$I_i^l$ est la valeur de sortie du second module d'intégration 402. $b_i^l$ représente une valeur de biais qui est la valeur initiale de l'accumulateur dans le second module d'intégration 402, $w_{ij}^l$ représente un coefficient synaptique.

La valeur de sortie $y_i^l$ est ensuite encodée via un codeur 403 selon l'invention (tel que décrit à la figure 2) qui code la valeur $y_j^l$ en plusieurs évènements qui sont propagés successivement vers un ou plusieurs autre(s) neurone(s).

Les différentes opérations mises en oeuvre successivement dans un neurone N peuvent être réalisées à des rythmes différents, c'est-à-dire avec des échelles de temps ou horloges différentes. Typiquement, le premier dispositif d'intégration 401 fonctionne à un rythme plus rapide que le second dispositif d'intégration 402 qui fonctionne lui-même à un rythme plus rapide que l'opérateur réalisant la fonction d'activation.

Dans le cas où les deux dispositifs d'intégration 401,402 fonctionnent au même rythme, un seul dispositif d'intégration est utilisé au lieu de deux. De façon générale, selon l'implémentation matérielle choisie, le nombre d'accumulateurs utilisé varie.

De façon similaire à ce qui a été décrit ci-dessus, les signaux d'erreur rétro-propagés durant la phase de rétro-propagation (phase backward) peuvent aussi être codés au moyen de la méthode de codage selon l'invention. Dans ce cas, un module d'intégration selon l'invention est implémenté dans chaque neurone pour réaliser la pondération des signaux d'erreurs codés reçus avec des coefficients synaptiques comme illustré sur la figure 5 qui représente un neurone artificiel configuré pour traiter et rétro-propager des signaux d'erreurs d'une couche I+1 vers une couche I.

Dans la phase de rétropropagation, le calcul d'erreur $\delta_i^l$ est implémenté selon l'équation suivante :
[Math. 2]

$$\delta_i^l = a'^l\big(I_i^l\big)\, E_i^l\,,\quad E_i^l = \sum_k \delta_k^{l+1}\, w_{ki}^{l+1}\quad (2)$$

$a'^l(I_i^l)$ est la valeur de la dérivée de la fonction d'activation.

Le neurone décrit à la figure 5 comprend un premier module d'intégration 501 du type de la figure 3 pour réaliser le calcul du produit $\delta_k^{l+1} w_{ki}^{l+1}$, avec $\delta_k^{l+1}$ le signal d'erreur reçu depuis un neurone de la couche I+1 et codé au moyen de la méthode de codage selon l'invention et $w_{ki}^{l+1}$ la valeur d'un coefficient synaptique.

Un second module d'intégration 502 classique est ensuite utilisé pour réaliser l'intégration des résultats du premier module 501 dans le temps.

Le neurone N comprend d'autres opérateurs spécifiques nécessaires pour calculer une erreur locale $\delta_i^l$ qui est ensuite codée via un codeur 503 selon l'invention qui code l'erreur sous la forme de plusieurs évènements qui sont ensuite rétro-propagés vers la couche précédente I-1.

Le neurone N comprend aussi, par ailleurs, un module de mise à jour des poids synaptiques 504 en fonction de l'erreur locale calculée.

Les différents opérateurs du neurone peuvent fonctionner à des rythmes ou échelles de temps différents. En particulier, le premier module d'intégration 501 fonctionne au rythme le plus rapide. Le second module d'intégration 502 fonctionne à un rythme plus lent que le premier module 501. Les opérateurs utilisés pour calculer l'erreur locale fonctionnent à un rythme plus lent que le second module 502.

Dans le cas où les deux modules d'intégration 501,502 fonctionnent au même rythme, un seul module d'intégration est utilisé au lieu de deux. De façon générale, selon l'implémentation matérielle choisie, le nombre d'accumulateurs utilisé varie.

L'invention propose un moyen d'adapter les opérateurs de calculs d'une architecture de calcul numérique en fonction des données reçues. Elle est particulièrement avantageuse pour les architectures implémentant des modèles d'apprentissage automatique, dans lesquelles la distribution des données à traiter varie beaucoup selon les entrées reçues.

L'invention présente notamment des avantages lorsque les valeurs à coder sont faibles et/ou lorsqu'elles contiennent beaucoup de bits à 0. En effet, les mots binaires nuls ne sont pas transmis après codage ce qui permet de diminuer le nombre d'opérations réalisées par le modèle d'apprentissage automatique.

Statistiquement, seulement 50% des bits sont nuls lorsqu'on considère des données binaires aléatoires. Par contre, les données propagées au sein d'un modèle d'apprentissage automatique. présentent un grand nombre de valeurs faibles ce qui implique un grand nombre de bits à 0 lorsque les valeurs sont toutes représentées avec le même nombre de bits.

Cette propriété s'explique notamment du fait que les données propagées par un modèle d'apprentissage automatique avec plusieurs couches de traitement, tel qu'un réseau de neurones, véhiculent de l'information qui se concentre, progressivement au cours de la propagation, vers un nombre réduit de neurones. De ce fait, les valeurs propagées vers les autres neurones sont proches de 0 ou de façon générale, faibles.

Une approche classique pour prendre en compte cette propriété particulière des signaux consiste à coder toutes les valeurs sur un nombre de bits faibles (par exemple 8 bits). Cependant, cette approche présente l'inconvénient d'être très impactante pour les valeurs qui dépassent la valeur maximale de quantification (par exemple $2^8$-1). En effet, ces valeurs sont écrêtées à la valeur maximale ce qui entraine des pertes de précision pour les valeurs qui véhiculent le plus d'information.

Cette approche n'est donc pas adaptée à ces types de modèles d'apprentissage automatique.

Une autre approche consiste toujours à coder les valeurs sur un nombre de bits fixe mais en réglant la dynamique de sorte à ne pas écrêter les valeurs maximales. Cette seconde approche présente l'inconvénient de modifier la valeur des données de valeur faibles qui sont très nombreuses.

Ainsi, la méthode de codage selon l'invention est particulièrement adaptée au profil statistique des valeurs propagées dans un modèle d'apprentissage automatique. car elle permet de prendre en compte toute la dynamique des valeurs sans pour autant utiliser un nombre de bits élevé fixe pour quantifier l'ensemble des valeurs. Ainsi, il n'y a pas de perte de précision due à la quantification des données mais les opérateurs utilisés pour l'implémentation d'un opérateur MAC peuvent être dimensionnés pour traiter des données de taille plus faible.

Un des avantages de l'invention est que le nombre de mots binaires et leur taille $N_p$ sont des paramètres de la méthode de codage.

Ces paramètres, en particulier la taille $N_p$, est optimisée en fonction des propriétés statistiques des données à coder. Cela permet d'optimiser le codage de sorte à optimiser la consommation d'énergie globale du calculateur ou circuit réalisant le modèle d'apprentissage automatique.

En effet, les paramètres de codage influent sur les valeurs qui sont propagées dans le modèle d'apprentissage automatique et donc sur la taille des opérateurs réalisant les opérations MAC.

En appliquant l'invention, le codage est paramétré de manière à minimiser le nombre d'opérations binaires réalisées ou plus généralement à minimiser ou optimiser la consommation d'énergie qui en découle.

Une première approche pour optimiser les paramètres de codage consiste à simuler le comportement d'un modèle d'apprentissage automatique pour un ensemble de données d'apprentissage et à simuler sa consommation d'énergie en fonction du nombre et de la taille des opérations réalisées. En faisant varier les paramètres de codage pour le même ensemble de données, on recherche les paramètres qui permettent de minimiser la consommation d'énergie.

Une seconde approche consiste à déterminer un modèle mathématique pour exprimer l'énergie consommée par le modèle d'apprentissage automatique ou plus généralement le calculateur visé, en fonction des paramètres de codage, en particulier $N_p$.

Dans le cas d'application d'un réseau de neurones, les paramètres de codage peuvent être différents selon la couche du réseau. En effet, les propriétés statistiques des valeurs propagées peuvent dépendre de la couche du réseau. Plus on avance dans les couches, plus l'information a tendance à se concentrer vers quelques neurones particuliers. Au contraire, dans les premières couches, la distribution de l'information dépend des données d'entrée du neurone, elle peut être plus aléatoire.

Un exemple de modèle mathématique pour un réseau de neurones est proposé par la suite.

L'énergie consommée $E^l$ par une couche d'un réseau dépend de l'énergie consommée $E_{int}^l(N_p)$ par l'intégration d'un évènement (une valeur reçue) par un neurone et de l'énergie $E_{enc}^{l-1}(N_p)$ consommée par l'encodage de cet évènement par la couche précédente.

Ainsi, un modèle de l'énergie consommée par une couche peut être formulé à l'aide de la relation suivante :
[Math. 3]

$$E^l = N_{hist}^{l-1}\left(N_p^l\right).\left(E_{enc}^{l-1}\left(N_p^l\right) + E_{int}^l\left(N_p^l\right).n_{int}^l\right)(3)$$

$n_{int}^l$ est le nombre de neurones de la couche l $N_{hist}^{l-1}\left(N_p^l\right)$ est le nombre d'évènements (mots binaires codés) transmis par la couche l-1. Ce nombre dépend du paramètre de codage $N_p^l$ et de la distribution des données.

A partir du modèle donné par la relation (3), on recherche la valeur de $Np$ qui permet de minimiser l'énergie consommée pour chaque couche $E^l$.

Les fonctions $E_{int}^l\left(N_p^l\right)$ et $E_{enc}^{l-1}\left(N_p^l\right)$ peuvent être déterminées à partir de modèles ou de fonctions empiriques au moyen de simulations ou à partir de mesures réelles.

Un avantage de l'invention est qu'elle permet de paramétrer la valeur de $N_p^l$ indépendamment pour chaque couche l du réseau, ce qui permet de prendre en compte finement le profil statistique des données propagées pour chaque couche.

L'invention peut être appliquée également pour optimiser le codage des valeurs d'erreurs rétropropagées lors d'une phase de rétro-propagation du gradient. Les paramètres de codage peuvent être optimisés indépendamment pour la phase de propagation et la phase de rétro-propagation.

Dans une variante de réalisation de l'invention, les valeurs des activations dans le réseau de neurones peuvent être contraintes de sorte à favoriser une distribution plus importante de valeurs faibles.

Cette propriété peut être obtenue en agissant sur la fonction de coût mise en oeuvre dans la dernière couche du réseau. En ajoutant un terme à cette fonction de coût qui dépend des valeurs des signaux propagés, on peut pénaliser les valeurs larges dans la fonction de cout et ainsi contraindre les activations dans le réseau à des valeurs plus faibles.

Cette propriété permet de modifier la distribution statistique des activations et ainsi d'améliorer l'efficacité de la méthode de codage.

La méthode de codage selon l'invention peut être avantageusement appliquée au codage de données propagées dans un calculateur mettant en oeuvre une fonction d'apprentissage automatique, par exemple une fonction de réseau de neurones artificiels pour classifier des données selon une fonction d'apprentissage.

La méthode de codage selon l'invention peut aussi être appliquée aux données d'entrées du réseau de neurones, autrement dit les données produites en entrée de la première couche du réseau. Dans ce cas, le profil statistique des données est exploité pour coder au mieux l'information. Par exemple, lorsqu'il s'agit d'images, les données à encoder peuvent correspondre à des pixels de l'image ou des groupes de pixels ou aussi à des différences entre pixels de deux images consécutives dans une séquence d'images (vidéo).

Le calculateur selon l'invention peut être implémenté à l'aide de composants matériels et/ou logiciels. Les éléments logiciels peuvent être disponibles en tant que produit programme d'ordinateur sur un support lisible par ordinateur, support qui peut être électronique, magnétique, optique ou électromagnétique. Les éléments matériels peuvent être disponibles tous ou en partie, notamment en tant que circuits intégrés dédiés (ASIC) et/ou circuits intégrés configurables (FPGA) et/ou en tant que circuits neuronaux selon l'invention ou en tant que processeur de signal numérique DSP et/ou en tant que processeur graphique GPU, et/ou en tant que microcontrôleur et/ou en tant que processeur général par exemple. Le calculateur CONV comprend également une ou plusieurs mémoires qui peuvent être des registres, registres à décalage, mémoire RAM, mémoire ROM ou tout autre type de mémoire adapté à la mise en oeuvre de l'invention.

## Revendications

1. Procédé, mis en oeuvre par ordinateur, de codage d'un signal numérique destiné à être traité par un système de calcul numérique, le procédé comprenant les étapes de :

   - Recevoir (101) un échantillon du signal numérique quantifié sur un nombre $N_d$ de bits,
   - Décomposer (102) l'échantillon en une pluralité de mots binaires de taille $N_p$ bits paramétrable, la taille $N_p$ d'un mot binaire étant déterminée en fonction de la distribution statistique des valeurs à 0 des bits du signal numérique, de manière à minimiser la consommation d'énergie dudit système de calcul numérique,
   - Coder (103) l'échantillon par une pluralité de couples de valeurs, chaque couple comprenant l'un des mots binaires et une adresse correspondant à la position du mot binaire dans l'échantillon,
   - Transmettre (104) les couples de valeurs à une unité d'intégration dudit système de calcul numérique pour réaliser une opération MAC entre l'échantillon et un coefficient de pondération,le procédé comprenant soit une étape de transmission dans laquelle seuls les couples de valeurs comprenant des mots binaires non nuls sont transmis soit une étape de suppression des mots binaires nuls avant de réaliser l'opération MAC.

2. Procédé de codage selon la revendication 1 dans lequel une même adresse correspondant à des mots binaires codés à partir de différents échantillons n'est transmise qu'une seule fois.

3. Procédé de codage selon l'une des revendications précédentes dans lequel la consommation d'énergie est estimée par simulation ou à partir d'un modèle empirique.

4. Procédé de codage selon l'une des revendications précédentes dans lequel le système de calcul numérique implémente un réseau de neurones artificiels.

5. Procédé de codage selon la revendication 4 dans lequel la taille $N_p$ des mots binaires est paramétrée de façon indépendante pour chaque couche du réseau de neurones artificiel.

6. Dispositif de codage (200) comprenant un codeur configuré pour exécuter le procédé de codage selon l'une des revendications précédentes.

7. Dispositif d'intégration (300) configuré pour réaliser une opération de multiplication puis accumulation MAC entre un premier nombre codé au moyen du dispositif de codage selon la revendication 6 et un coefficient de pondération, le dispositif comprenant un multiplieur (MUL) pour multiplier le coefficient de pondération avec le mot binaire du premier nombre, un registre à décalage (REG) configuré pour décaler le signal de sortie du multiplieur (MUL) de la valeur de l'adresse dudit mot binaire, un additionneur (ADD) et un registre d'accumulation (RAC) pour accumuler le signal de sortie du registre à décalage (REG).

8. Neurone artificiel (N), mis en oeuvre par un système de calcul numérique, comprenant un dispositif d'intégration (300,401) selon la revendication 7 pour réaliser une opération de multiplication puis accumulation MAC entre un signal reçu et un coefficient synaptique, et un dispositif de codage (200,403) selon la revendication 6 pour coder le signal de sortie du dispositif d'intégration (300,401), le neurone artificiel (N) étant configuré pour propager le signal codé vers un autre neurone artificiel.

9. Neurone artificiel (N), mis en oeuvre par un calculateur, comprenant un dispositif d'intégration (300,501) selon la revendication 7 pour réaliser une opération de multiplication puis accumulation MAC entre un signal d'erreur reçu depuis un autre neurone artificiel et un coefficient synaptique, un module de calcul d'erreur locale configuré pour calculer un signal d'erreur locale à partir du signal de sortie du dispositif d'intégration (300,501) et un dispositif de codage (200,503) selon la revendication 6 pour coder le signal d'erreur locale, le neurone artificiel (N) étant configuré pour rétro-propager le signal d'erreur locale vers un autre neurone artificiel.

10. Réseau de neurones artificiels comprenant une pluralité de neurones artificiels selon l'une quelconque des revendications 8 ou 9.

**Patentansprüche**

1. Computerimplementiertes Verfahren zur Codierung eines digitalen Signals, das zur Verarbeitung durch ein digitales Rechensystem bestimmt ist, wobei das Verfahren die folgenden Schritte umfasst:

   - Empfangen (101) eines Abtastwertes des digitalen Signals, das auf eine Anzahl $N_d$ von Bits quantisiert ist,
   - Zerlegen (102) des Abtastwertes in eine Vielzahl von Binärwörtern mit einer parametrisierbaren Größe $N_p$ Bits, wobei die Größe $N_p$ eines Binärwortes in Abhängigkeit von der statistischen Verteilung der 0-Werte der Bits des digitalen Signals bestimmt wird, um den Energieverbrauch des digitalen Rechensystems zu minimieren,
   - Codieren (103) des Abtastwertes durch eine Vielzahl von Wertepaaren, wobei jedes Paar eines der Binärwörter und eine Adresse umfasst, die der Position des Binärwortes in dem Abtastwert entspricht,
   - Übertragen (104) der Wertepaare an eine Integrationseinheit des digitalen Rechensystems, um einen MAC-Vorgang zwischen dem Abtastwert und einem Gewichtungskoeffizienten durchzuführen, wobei das Verfahren entweder einen Übertragungsschritt, bei dem nur die Wertepaare, die von Null verschiedene Binärwörter umfassen, übertragen werden, oder einen Lösch-Schritt der Null-Binärwörter vor dem Durchführen des MAC-Vorgangs umfasst.

2. Codierverfahren nach Anspruch 1, wobei eine gleiche Adresse, die anhand von verschiedenen Abtastwerten codierten Binärwörtern entspricht, nur einmal übertragen wird.

3. Codierverfahren nach einem der vorhergehenden Ansprüche, wobei der Energieverbrauch durch Simulation oder anhand eines empirischen Modells geschätzt wird.

4. Codierverfahren nach einem der vorhergehenden Ansprüche, wobei das digitale Rechensystem ein künstliches neuronales Netz implementiert.

**5.** Codierverfahren nach Anspruch 4, wobei die Größe $N_p$ der Binärwörter für jede Schicht des künstlichen neuronalen Netzes unabhängig parametrisiert wird.

**6.** Codiervorrichtung (200), die einen Codierer umfasst, der so konfiguriert ist, dass er das Codierverfahren nach einem der vorhergehenden Ansprüche ausführt.

**7.** Integrationsvorrichtung (300), die so konfiguriert ist, dass sie einen Multiplikations- und einen anschließenden Akkumulationsvorgang MAC zwischen einer ersten Zahl, die mittels der Codiervorrichtung nach Anspruch 6 codiert ist, und einem Gewichtungskoeffizienten durchführt, wobei die Vorrichtung einen Multiplizierer (MUL) zum Multiplizieren des Gewichtungskoeffizienten mit dem Binärwort der ersten Zahl, ein Schieberegister (REG), das so konfiguriert ist, dass es das Ausgangssignal des Multiplizierers (MUL) um den Wert der Adresse des Binärwortes verschiebt, einen Addierer (ADD) und ein Akkumulationsregister (RAC), um das Ausgangssignal des Schieberegisters (REG) zu akkumulieren, umfasst.

**8.** Künstliches Neuron (N), implementiert durch ein digitales Rechensystem, umfassend eine Integrationsvorrichtung (300, 401) nach Anspruch 7, um einen Multiplikations- und einen anschließenden Akkumulationsvorgang MAC zwischen einem empfangenen Signal und einem synaptischen Koeffizienten durchzuführen, und eine Codiervorrichtung (200, 403) nach Anspruch 6, um das Ausgangssignal der Integrationsvorrichtung (300, 401) zu codieren, wobei das künstliche Neuron (N) so konfiguriert ist, dass es das codierte Signal an ein anderes künstliches Neuron propagiert.

**9.** Künstliches Neuron (N), implementiert durch einen Rechner, umfassend eine Integrationsvorrichtung (300, 501) nach Anspruch 7, um einen Multiplikations- und einen anschließenden Akkumulationsvorgang MAC zwischen einem von einem anderen künstlichen Neuron empfangenen Fehlersignal und einem synaptischen Koeffizienten durchzuführen, ein lokales Fehlerberechnungsmodul, das konfiguriert ist, um ein lokales Fehlersignal aus dem Ausgangssignal der Integrationsvorrichtung (300, 501) zu berechnen, und eine Codiervorrichtung (200, 503) nach Anspruch 6, um das lokale Fehlersignal zu codieren, wobei das künstliche Neuron (N) konfiguriert ist, um das lokale Fehlersignal an ein anderes künstliches Neuron rückwärts zu propagieren.

**10.** Künstliches neuronales Netz umfassend eine Vielzahl von künstlichen Neuronen nach einem der Ansprüche 8 oder 9.

**Claims**

**1.** A computer-implemented method for coding a digital signal intended to be processed by a digital computing system, the method comprising the steps of:

- receiving (101) a sample of the digital signal quantized on a number $N_d$ of bits,
- decomposing (102) the sample into a plurality of binary words of parameterizable size $N_p$ bits, wherein the size $N_p$ of a binary word is determined as a function of the statistical distribution of the 0-values of the bits of the digital signal, so as to minimize the power consumption of said digital computing system,
- coding (103) the sample through a plurality of pairs of values, each pair comprising one of the binary words and an address corresponding to the position of the binary word in the sample,
- transmitting (104) the pairs of values to an integration unit of said digital computing system in order to perform a MAC operation between the sample and a weighting coefficient, the method comprising either a transmission step in which only those value pairs comprising non-zero binary words are transmitted or a step of deleting the zero binary words before performing the MAC operation.

**2.** The coding method according to claim 1, wherein one and the same address corresponding to binary words coded from various samples is transmitted only once.

**3.** The coding method according to one of the preceding claims, wherein the energy consumption is estimated by simulation or on the basis of an empirical model.

**4.** The coding method according to one of the preceding claims, wherein the digital computing system implements an artificial neural network.

**5.** The coding method according to claim 4, wherein the size $N_p$ of the binary words is parameterized independently for each layer of the artificial neural network.

6. A coding device (200) comprising a coder configured to execute the coding method according to one of the preceding claims.

7. An integration device (300) configured to perform a multiply-then-accumulate MAC operation between a first number coded by means of the coding device according to claim 6 and a weighting coefficient, the device comprising a multiplier (MUL) for multiplying the weighting coefficient by the binary word of the first number, a shift register (REG) configured to shift the output signal from the multiplier (MUL) by the value of the address of said binary word, an adder (ADD) and an accumulation register (RAC) for accumulating the output signal from the shift register (REG).

8. An artificial neuron (N), implemented by a digital computing system, comprising an integration device (300, 401) according to claim 7 for performing a multiply-then-accumulate MAC operation between a received signal and a synaptic coefficient, and a coding device (200, 403) according to claim 6 for coding the output signal from the integration device (300, 401), the artificial neuron (N) being configured to propagate the coded signal to another artificial neuron.

9. An artificial neuron (N), implemented by a computer, comprising an integration device (300, 501) according to claim 7 for performing a multiply-then-accumulate MAC operation between an error signal received from another artificial neuron and a synaptic coefficient, a local error computing module configured to compute a local error signal on the basis of the output signal from the integration device (300, 501) and a coding device (200, 503) according to claim 6 for coding the local error signal, the artificial neuron (N) being configured to back-propagate the local error signal to another artificial neuron.

10. An artificial neural network comprising a plurality of artificial neurons according to any one of claims 8 and 9.

FIG.1

FIG.2

w    p    @    **sign**

300

MUL

REG

ADD    INC

RAC

# FIG.3

FIG.4

FIG.5

**EP 4 078 816 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2016050595 A
- US 2019065150 A1, HEDDES MATTHEUS COR-NELIS ANTONIUS ADRIANUS
- US 9818059 B1, WOO DONG HYUK
- US 2016358069 A1, BROTHERS JOHN W
- EP 3343392 A1